Europäisches Patentamt

European Patent Office

Office européen des brevets

(19)

(11) **EP 0 825 720 B1**

(12) **FASCICULE DE BREVET EUROPEEN**

(45) Date de publication et mention
de la délivrance du brevet:
**18.06.2003 Bulletin 2003/25**

(51) Int Cl.⁷: **H03M 1/12**, G02F 7/00

(21) Numéro de dépôt: **97401975.4**

(22) Date de dépôt: **22.08.1997**

(54) **Convertisseur analogique/numérique**

Analog-Digital-Wandler

Analogue to digital converter

(84) Etats contractants désignés:
**DE GB IT**

(30) Priorité: **23.08.1996 FR 9610403**

(43) Date de publication de la demande:
**25.02.1998 Bulletin 1998/09**

(73) Titulaire: **Thales**
**75008 Paris (FR)**

(72) Inventeurs:
• **d'Auria, Luigi**
**94117 Arcueil Cedex (FR)**
• **Huignard, Jean-Pierre**
**94117 Arcueil Cedex (FR)**

(56) Documents cités:
**US-A- 5 010 346**

• **MASON R ET AL: "HIGH-SPEED
ELECTRO-OPTIC ANALOGUE TO DIGITAL
CONVERTERS" PROCEEDINGS OF THE
INTERNATIONAL SYMPOSIUM ON CIRCUITS
AND SYSTEMS (ISCS), CHICAGO, MAY 3 - 6,
1993, vol. 2 OF 4, 3 mai 1993, INSTITUTE OF
ELECTRICAL AND ELECTRONICS ENGINEERS,
pages 1081-1084, XP000379161**

## Description

L'invention concerne un convertisseur analogique/numérique de signaux électriques.

Les convertisseurs analogiques/numériques de types connus ont un rapport fréquence d'échantillonnage - nombre de bits de numérisation limité. Plus précisément, on est limité par la fréquence d'échantillonnage. Par exemple, avec un échantillonnage 1 GHz on numérisera le signal sur 10 bits.

Le brevet US 5,010,346 (Hamilton et al.) décrit un convertisseur analogique/numérique électro-optique, avec une fréquence d'échantillonnage accru, basé sur la modulation d'impulsions lumineuses décalées temporellement, par un signal électrique analogique à numériser. Chaque impulsion lumineuse modulée est ensuite détectée par un photodétecteur puis numérisée par un convertisseur analogique/numérique.

L'invention a pour objet d'augmenter la fréquence d'échantillonnage tout en permettant une numérisation avec un aussi grand nombre de bits (10 bits) grâce à un convetisseur analogique/numérique électro-optique dans lequel sont prévus en outre des circuits optiques d'expansion temporelle de chaque impulsion lumineuse modulée, permettant l'utilisation de convertisseurs analogiques/numériques électriques standard tout en obtenant des performances remarquables en terme d'échantillonage (typiquement de l'ordre de 10 GHz de fréquence d'échantillonnage avec une numérisation sur 10 bits).

Plus précisément, l'invention concerne un convertisseur analogique/ numérique tel que décrit dans la revendication 1.

Les différents objets et caractéristiques de l'invention apparaîtront plus clairement dans la description qui va suivre et dans les figures annexées qui représentent :

- la figure 1, un exemple de réalisation du convertisseur analogique/numérique selon l'invention ;
- la figure 2, un diagramme de fonctionnement du système de la figure 1 ;
- les figures 3a à 3d, un dispositif d'expansion temporelle d'impulsion lumineuse ;
- la figure 4, un diagramme de fonctionnement du dispositif d'expansion des figures 3a à 3d ;

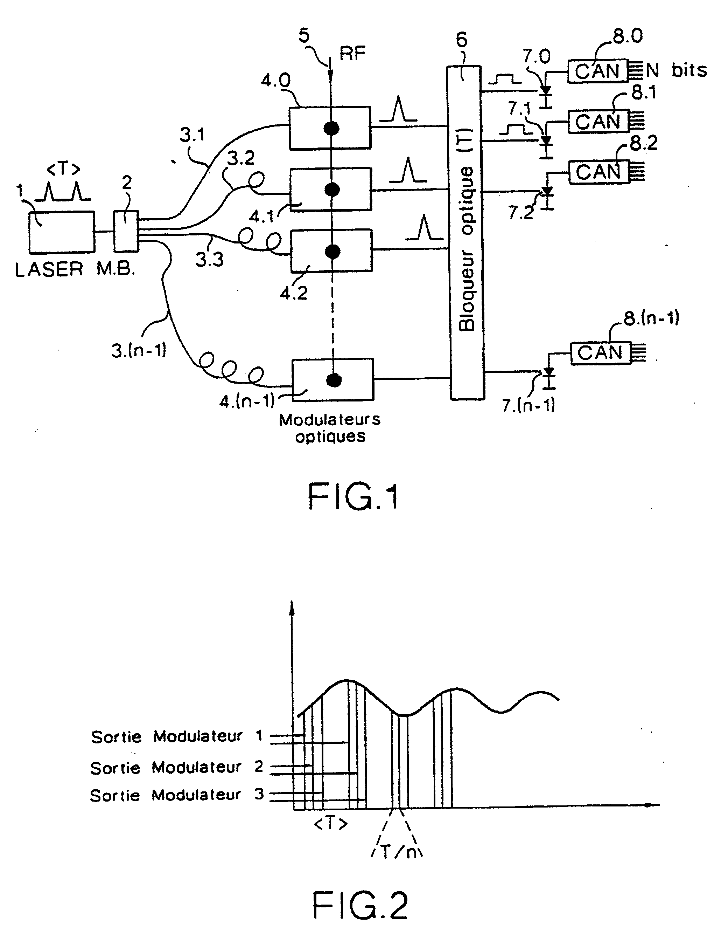

Le système de la figure 1 comporte une source optique 1 telle qu'un laser impulsionnel à mode bloqué fournissant un train d'impulsions ultrafines avec une période déterminée T.

L'énergie lumineuse de la source 1 est couplée à l'entrée d'un coupleur optique 2 à une entrée et n sorties. Ce coupleur répartit l'énergie lumineuse sur les n sorties.

A chaque sortie est connecté un circuit à retard optique 3.0 à 3.(n-1). Les différents circuits à retards induisent des retards de valeurs différentes. Dans le cas d'un train d'impulsions, la valeur du plus grand retard est strictement inférieure à la période T.

Dans un mode de réalisation préféré, les différents retards sont incrémentés d'un circuit à retard au suivant d'une valeur constante et leur somme est également à là période T. Les différents retards ont pour valeurs :

$$0, T/n, 2T/n, ..., (n-1) T/n$$

Selon l'exemple de réalisation les circuits à retards sont réalisés avec des fibres optiques présentant des incréments de longueurs les unes par rapport aux autres de

$$L = (T/n) (C/nf)$$

C : étant la vitesse de la lumière

nf: l'indice du coeur de la fibre

Les n sorties des n circuits à retard sont connectées à n modulateurs électrooptiques 4.0 à 4.(n-1) commandés simultanément par un signal électrique à numériser reçu sur une commande électrique 5.

A la sortie de chaque modulateur, on retrouve un train d'impulsions lumineuses de période T, l'amplitude de chaque impulsion étant proportionnelle à celle du signal RF à l'instant du passage de l'impulsion dans le modulateur. Les sorties des modulateurs constituent donc n canaux parallèles fournissant l'échantillonnage du signal électrique avec une période d'échantillonnage $T/n$. Les sorties des modulateurs fournissent donc des trains d'impulsions lumineuses modulées. Chaque sortie de modulateur est couplée à une photodiode 7.0 à 7(n-1) dont les signaux électriques de photodétection sont fournis à un convertisseur analogique numérique électrique 8.0 à 8(n-1).

Afin de rendre ces échantillons compatibles avec la bande passante et la fréquence d'échantillonnage de convertisseurs analogiques/numériques électriques, il est nécessaire de bloquer l'amplitude de chacun des échantillons pendant une période de temps égale à la période d'échantillonnage des convertisseurs anaiogiques/numériques.

Pour ce faire, les échantillons impulsionnels sont dirigés vers un bloqueur optique 6.

Les n signaux électriques générés par les n photodiodes sont donc numérisés par n convertisseurs analogiques/numériques. Chaque convertisseur a de préférence une période d'échantillonnage égale à T et une résolution de N bits.

A compter d'un temps $t_0$, le convertisseur 8.0 fournit l'amplitude numérisée des échantillons aux temps $t_0$, $t_0 + T$, $t_0 + 2T$ ...., le convertisseur 8.1 fournit une information du même type aux temps $t_0 + T/n$, $t_0 + T/n + T$, $t_0 + T/_n + 2T$ ... et le convertisseur 8.(n-1), au temps $t_0 + (n-1) T/n$, $t_0 + (n-1) T/n+T$, $t_0 + (n-1) T/n + 2T$, etc.

Le signal électrique est donc finalement échantillonné avec une période égale à $T/n$ et une résolution égale à N bits.

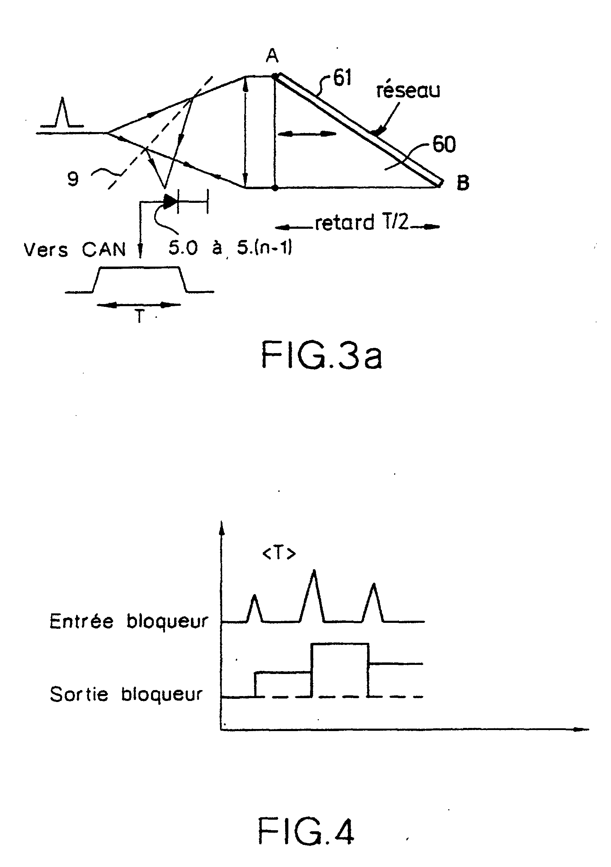

La figure 3a représente un exemple de réalisation d'un bloqueur 6. Ce bloqueur est constitué d'un prisme rectangle 60 dont la face hypoténuse est munie d'un réseau 61. L'énergie lumineuse issue d'un circuit à retard est collimatée sur une des faces du prisme, propagée à l'intérieur de celui-ci, réfléchie par un réseau 61 et refocalisée sur une photodiode 7.0 à 7(n-1) via une lame semi-réfléchissante 9. Du fait des différences de temps de propagation à l'intérieur du prisme, l'impulsion reçue par chaque photodiode sera "étalée". De préférence, cet étalement est d'une durée T dans le cas où le plus grand chemin optique dans un sens à l'intérieur du prisme correspond à un temps de propagation égal à T/2.

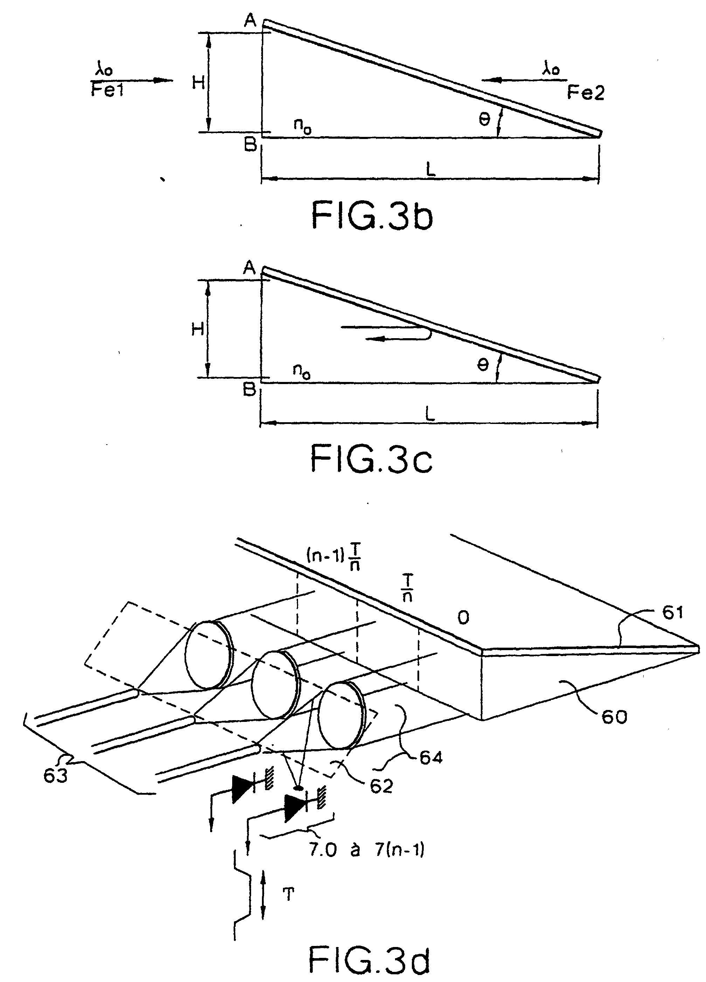

La figure 4 montre la forme des signaux à l'entrée et à la sortie d'un bloqueur 6 qui présente par ailleurs la caractéristique remarquable d'être un dispositif passif et qui a une fonction collective pour les n voies (voir l'exemple de la figure 3d).

Les figures 3b et 3c représentent une forme de réalisation du réseau 61 sous forme d'un réseau holographique de volume. La figure 3b montre l'enregistrement du réseau à l'aide de deux faisceaux Fe1 et Fe2 à une longueur d'onde $\lambda_o$. La figure 3c montre son fonctionnement en lecture. Si les deux faisceaux Fe1 et Fe2 sont contrapropagatifs, le réseau . fonctionnera en figure 3c comme un rétroréflecteur.

Le bloqueur 6 des figures 3a à 3b fonctionne en réflexion. Dans ces conditions, le retard introduit par les deux extrémités A et B du réseau s'écrit :

$$T = 2n_o \frac{L}{C} \text{ soit } T = \frac{2H}{tg\theta} \times \frac{n_o}{C}$$

avec

- θ angle du prisme ;
- H et L respectivement hauteur et longueur du prisme.

En d'autres termes, la réponse impulsionnelle d'un tel prisme est un créneau de largeur T au foyer de la lentille L.

Exemple de réalisation :

- L'impulsion étant courte ($\sim$ 30 fts) il est préférable d'assurer la réflexion du faisceau incident par un réseau non dispersif (et non pas par une structure classique du type réseau de Littrow). Cette fonction est réalisée par un réseau holographique de volume par réflexion enregistré dans un matériau photopolymère à haute efficacité de diffraction ;
- Dimensionnement géométrique H = 1 cm ; $n_o$ = 2 ; L = 7,5 cm

Le bloqueur 6 peut être commun à plusieurs modulateurs 5.0 à 5(n-1) et donc à plusieurs photodiodes. La figure 3d représente une structure d'un tel dispositif. La lumière issue des différents modulateurs 5.0 à 5(n-1) arrive sur le bloqueur par les fibres 63 (par exemple). Les lentilles 64 collimatent les différents faisceaux vers le prisme 60 et le réseau 61. Les différent faisceaux sont rétroréfléchis et sont réfléchis par un séparateur de faisceau 62 (lame semi-transparente) vers les photodiodes 7.à à 7(n-1).

En utilisant des convertisseurs analogiques/numériques 8.0 à 8(n-1) de caractéristiques 10 bits-1 GHz, l'invention permet de réaliser, par exemple un convertisseur 10 bits-10 Ghz.

Le rapport signal sur bruit S/B, exprimé en dB, nécessaire à l'entrée des convertisseurs électriques 8.0 à 8(n-1) pour pouvoir assurer une résolution de N bits est donné par :

$$S/B > (6,02 \text{ N} + 1,76)$$

Pour N = 10, S/B > 62 dB électriques soit 31 dB en rapport de puissances optiques.

Les impulsions présentées aux convertisseurs électriques ont une largeur de 1 ns détectables par exemple par des photorécepteurs ayant une bande passante de 2 GHz (temps de montée et de descente de l'ordre de 175 ps) et une puissance optique équivalente au bruit (NEP) de l'ordre de -50 dBm.

Dans ces conditions, et afin d'assurer un rapport S/B d'au moins 61 dB électriques, les photodiodes doivent voir un signal optique ayant une puissance de l'ordre de

-50 dBm + 31 dB = -19 dBm, soit $\sim$ 10 micro Watts

Si on suppose une largeur des impulsions émises par le laser de l'ordre de 30 fs (compatible avec une période d'échantillonnage de 100 ps et une résolution de 10 bits, soit 1 024 niveaux), la puissance crête des impulsions fs reçues est de l'ordre de

10 micro Watts x (1 ns/30 fs) $\sim$ 0,3 Watt

En considérant la distribution sur 10 canaux et en supposant des pertes d'insertion des modulateurs et des couplages de 5 dB, on peut estimer la puissance crête des impulsions émises par le laser MB à 10 Watts (puissance moyenne : 10 W x (30 fs/1 ns) = 30 mW).

Pour réaliser le convertisseur tel que décrit précédemment on pourra utiliser une source laser ayant les caractéristiques suivantes :

- largeur de l'impulsion : 30 fts
- période de répétition : T = 1ns
- puissance moyenne : P = 30 mW

La durée de l'impulsion implique l'utilisation d'un matériau à très large bande spectrale comme le Saphire-Ti placé à l'intérieur d'une cavité courte dont la longueur Lc est adaptée à la période de répétition T = $\frac{2L_c}{c}$ soit $L_c \sim 15$ cm.

Le blocage des modes est assuré, soit par modulation acoustooptique intracavité - fréquence de modulation 1 GHz - soit par auto-blocage des modes par un matériau non linéaire dont le temps de réponse est inférieur à 1 ns. Le matériau est pompé par un laser continu YAG doublé en fréquence émettant à $\lambda = 530$ nm. Une puissance de pompe de l'ordre de 500 mW est requise pour obtenir une puissance moyenne de 30 mW à la longueur d'onde moyenne de 800 nm du laser Saphire-Ti (efficacité optique $\leq 10$ %). Notons que des composants optiques placés intracavité (prismes ou réseaux) seront nécessaires pour compenser les effets de dispersion de la cavité.

Le dispositif selon l'invention présente l'avantage de permettre le fonctionnement en parallèle de convertisseurs analogiques-numériques électroniques. Typiquement des performances du type 10 GHz de période d'échantillonnage et 10 bits sont réalisables à partir d'une source laser émettant des impulsions ultracourtes.

Il permet en outre d'utiliser des convertisseurs analogiques/numériques électriques standards.

## Revendications

1. Convertisseur analogique/numérique comprenant :

   - une source optique (1) fournissant au moins une impulsion lumineuse ;
   - un coupleur optique (2) à une entrée et n sorties recevant l'impulsion lumineuse de la source et répartissant son énergie sur les différentes sorties ;
   - n circuits à retards optiques (3.0 à 3.n-1) connectés chacun par une entrée à une sortie du coupleur, et fournissant sur une sortie une impulsion lumineuse retardée ;
   - n modulateurs électrooptiques (4.0 à 4.n-1) connectés chacun par une entrée à une sortie d'un circuit à retard ;
   - un circuit électrique (5) d'application d'un même signal électrique à numériser aux n modulateurs électrooptiques permettant à chaque modulateur de fournir sur une sortie une impulsion lumineuse d'amplitude modulée fonction de l'amplitude du signal électrique ;
   - n photodétecteurs (7.0 à 7.n-1) recevant chacun une impulsion lumineuse et fournissant une impulsion électrique correspondante ;

   n convertisseurs électriques analogiques/numériques (8.0 à 8.n-1) connectés chacun à un photodétecteur et convertissant l'amplitude d'un signal électrique en un signal numérique

**caractérisé en ce qu'**il comprend en outre n circuits optiques d'expansion temporelle (6) connectés chacun à une sortie d'un modulateur, recevant chacun une impulsion modulée et fournissant une impulsion lumineuse étendue dans le temps, chacun des n photodétecteurs recevant une impulsion lumineuse étendue.

2. Convertisseur selon la revendication 1, **caractérisé en ce que** la source optique (1) fournit un signal optique d'impulsions lumineuses et **en ce que** la valeur du plus grand retard optique fournit par l'un des n circuits à retards est inférieure à une période du signal optique.

3. Convertisseur selon la revendication 2, **caractérisé en ce que** le signal optique est périodique, de période donnée (T).

4. Convertisseur selon l'une des revendications 2 ou 3,, **caractérisé en ce que** les incréments de retards des circuits à retard consécutifs sont égaux.

5. Convertisseur selon l'une des revendications 3 ou 4, **caractérisé en ce que** chacun des n convertisseurs analogiques/numériques (8.0 à 8.n-1) a une période d'échantillonnage égale à la période (T) du signal optique et **en ce que** chaque impulsion est étalée d'une durée égale à ladite période (T).

6. Convertisseur selon l'une des revendications précédentes, **caractérisé en ce que** chaque circuit optique d'expansion temporelle comporte un réseau de diffraction incliné par rapport à la direction de propagation de l'impulsion modulée qu'il reçoit.

7. Convertisseur selon la revendication 6, **caractérisé en ce que** le réseau de diffraction fonctionne en réflexion.

8. Convertisseur selon la revendication 7, **caractérisé en ce que** le réseau de diffraction fonctionne en rétro-réflexion et qu'il comporte un séparateur de faisceau permettant d'aiguiller l'impulsion lumineuse rétro-réfléchie vers le photodétecteur.

9. Convertisseur selon l'une des revendications 6 à 8, **caractérisé en ce que** le réseau de diffraction est commun aux n circuits optiques d'expansion temporelle.

10. Convertisseur selon l'une des revendications 6 à 9, **caractérisé en ce que** ledit réseau est un réseau holographique de volume par réflexion.

11. Convertisseur selon l'une des revendications précédentes, **caractérisé en ce que** la source optique est une source laser impulsionnelle de puissance moyenne 30 mWatts, émettant des impulsions lumineuses avec une période (T) de 1 ns et une largeur d'impulsion de 30 fts.

12. Convertisseur selon l'une des revendications précédentes, **caractérisé en ce que** les circuits à retards optiques (3.0 à 3.n-1) comportent des fibres optiques de longueurs différentes.

**Patentansprüche**

1. Analog/Digitalwandler

   - mit einer Lichtquelle (1), die mindestens einen Lichtimpuls liefert,
   - mit einem optischen Koppler (2), der einen Eingang und n Ausgänge besitzt, den Lichtimpuls von der Quelle empfängt und dessen Energie auf die verschiedenen Ausgänge verteilt;
   - mit n optischen Verzögerungsgliedern (3.0 bis 3.(n-1)), die je mit einem Eingang an einen Ausgang des Kopplers angeschlossen sind und an einem Ausgang einen verzögerten Lichtimpuls liefern,
   - mit n elektro-optischen Modulatoren (4.0 bis 4.(n-1)), die je mit einem Eingang an einen Ausgang eines Verzögerungsglieds angeschlossen sind,
   - mit einer elektrischen Schaltung (5), die ein zu digitalisierendes elektrisches Signal an die n elektro-optische Modulatoren anlegt, wodurch jeder Modulator an einem Ausgang einen Lichtimpuls einer Amplitude liefern kann, die abhängig von der Amplitude des elektrischen Signals moduliert ist,
   - mit n Photodetektoren (7.0 bis 7.(n-1)), die je einen Lichtimpuls empfangen und einen entsprechenden elektrischen Impuls liefern,
   - und mit n elektrischen Analog/Digitalwandlern (8.0 bis 8.(n-1)), die je an einen der Photodetektoren angeschlossen sind und die Amplitude eines elektrischen Signals in einen Digitalwert umwandeln,

   **dadurch gekennzeichnet, daß** der Wandler außerdem n optische Glieder (6) zur zeitlichen Impulsverbreiterung enthält, die je an den Ausgang eines Modulators angeschlossen sind und je einen modulierten Impuls empfangen und einen zeitlich verbreiterten Lichtimpuls liefern, wobei jeder der n Photodetektoren einen solchen verbreiterten Lichtimpuls empfängt.

2. Wandler nach Anspruch 1, **dadurch gekennzeichnet, daß** die Lichtquelle (1) ein impulsförmiges Lichtsignal liefert und daß der größte Wert der optischen Verzögerung, der von einem der n Verzögerungsglieder geliefert wird, unterhalb einer Periode des optischen Signals liegt.

3. Wandler nach Anspruch 2, **dadurch gekennzeichnet, daß** das optische Signal ein periodisches Signal einer gegebenen Periode (T) ist.

4. Wandler nach einem der Ansprüche 2 und 3, **dadurch gekennzeichnet, daß** die Verzögerungsinkremente der aufeinanderfolgenden Verzögerungsglieder gleich sind.

5. Wandler nach einem der Ansprüche 3 und 4, **dadurch gekennzeichnet, daß** jeder der n Analog/Digitalwandler (8.0 bis 8.(n-1)) eine Tastperiode gleich der Periode (T) des optischen Signals besitzt und daß jeder Impuls auf eine Dauer gleich dieser Periode (T) verbreitet ist.

6. Wandler nach einem der vorstehenden Ansprüche, **dadurch gekennzeichnet, daß** jedes optische Glied zur zeitlichen Verbreiterung ein Beugungsgitter enthält, das bezüglich der Ausbreitungsrichtung des zu empfangenden modulierten Impulses geneigt ist.

7. Wandler nach Anspruch 6, **dadurch gekennzeichnet, daß** das Beugungsgitter reflektierend wirkt.

8. Wandler nach Anspruch 7, **dadurch gekennzeichnet, daß** das Beugungsgitter als Rückstrahler wirkt und einen Strahlseparator enthält, der den reflektierten Lichtimpuls auf den Photodetektor zu lenken erlaubt.

9. Wandler nach einem der Ansprüche 6 bis 8, **dadurch gekennzeichnet, daß** das Beugungsgitter für die n optischen Glieder zur zeitlichen Impulsausdehnung gemeinsam vorgesehen ist.

10. Wandler nach einem der Ansprüche 6 bis 9, **dadurch gekennzeichnet, daß** das Gitter ein räumlich-holographisches Gitter ist, das reflektiert.

11. Wandler nach einem der vorstehenden Ansprüche, **dadurch gekennzeichnet, daß** die Lichtquelle eine Impuls-Laserquelle einer mittleren Leistung von 30 mW ist, die Lichtimpulse mit einer Periode (T) von 1 ns und einer Impulsbreite von 30 fs emittiert.

12. Wandler nach einem der vorstehenden Ansprüche, **dadurch gekennzeichnet, daß** die optischen Verzögerungsglieder (3.0 bis 3.(n-1)) Lichtleitfasern unterschiedlicher Länge besitzen.

## Claims

1. Analogue/digital converter comprising:

   - an optical source (1) providing at least one light pulse;
   - an optical coupler (2) with an input and n outputs receiving the light pulse from the source and apportioning its energy over the various outputs;
   - n optical delay circuits (3.0 to 3.n-1) each connected by an input to an output of the coupler, and providing a delayed light pulse on an output;
   - n electrooptical modulators (4.0 to 4.n-1) each connected by an input to an output of a delay circuit;
   - an electrical circuit (5) for applying one and the same electrical signal to be digitized to the n electrooptical modulators allowing each modulator to provide on an output a light pulse of modulated amplitude dependent on the amplitude of the electrical signal;
   - n photodetectors (7.0 to 7.n-1) each receiving a light pulse and providing a corresponding electrical pulse;

   n analogue/digital electrical converters (8.0 to 8.n-1) each connected to a photodetector and converting the amplitude of an electrical signal into a digital signal **characterized in that** it furthermore comprises n time-expansion optical circuits (6) each connected to an output of a modulator, each receiving a modulated pulse and providing a light pulse stretched over time, each of the n photodetectors receiving a stretched light pulse.

2. Converter according to Claim 1, **characterized in that** the optical source (1) provides an optical signal of light pulses and **in that** the value of the largest optical delay provided by one of the n delay circuits is less than a period of the optical signal.

3. Converter according to Claim 2, **characterized in that** the optical signal is periodic, of given period (T).

4. Converter according to one of Claims 2 or 3, **characterized in that** the increments of delays of the consecutive delay circuits are equal.

5. Converter according to one of Claims 3 or 4, **characterized in that** each of the n analogue/digital converters (8.0 to 8.n-1) has a sampling period equal to the period (T) of the optical signal and **in that** each pulse is spread by a duration equal to the said period (T).

6. Converter according to one of the preceding claims, **characterized in that** each time-expansion optical circuit comprises a diffraction grating tilted with respect to the direction of propagation of the modulated pulse that it receives.

7. Converter according to Claim 6, **characterized in that** the diffraction grating operates in reflection mode.

8. Converter according to Claim 7, **characterized in that** the diffraction grating operates in back-reflection mode and that it comprises a beam splitter making it possible to steer the back-reflected light pulse towards the photodetector.

9. Converter according to one of Claims 6 to 8, **characterized in that** the diffraction grating is common to the n time-expansion optical circuits.

10. Converter according to one of Claims 6 to 9, **characterized in that** the said grating is a reflection volume holographic grating.

11. Converter according to one of the preceding claims, **characterized in that** the optical source is a pulsed laser source of mean power 30 mWatts, emitting light pulses with a period (T) of 1 ns and a pulse width of 30 fs.

12. Converter according to one of the preceding claims, **characterized in that** the optical delay circuits (3.0 to 3.n-1) comprise optical fibres of different lengths.

FIG.1

FIG.2

**FIG.3a**

**FIG.4**

FIG.3b

FIG.3c

FIG.3d